# EUROPÄISCHE PATENTSCHRIFT

(11) **EP 2 050 120 B1**
(45) Veröffentlichungstag und Bekanntmachung des Hinweises auf die Patenterteilung: **09.03.2011**
(21) Anmeldenummer: 07817428.1
(22) Anmeldetag: 08.08.2007
(51) Int. Cl.: H01J 37/32

(54) **ECR-PLASMAQUELLE**
ECR PLASMA SOURCE
SOURCE DE PLASMA ECR

(30) Priorität: 09.08.2006 DE 102006037144
(43) Veröffentlichungstag der Anmeldung: 22.04.2009
(73) Patentinhaber: Roth & Rau - MicroSystems GmbH, Gewerbering 3 09337 Hohenstein-Ernstthal (DE)
(72) Erfinder: MAI, Joachim, 04603 Nobitz (DE); FELL, Valeri, 08371 Glauchau (DE); RAU, Bernd, 09224 Chemnitz (DE)
(74) Vertreter: Pätzelt, Peter
(86) Internationale Anmeldenummer: PCT/DE2007/001441
(87) Internationale Veröffentlichungsnummer: WO 2008/017304

(56) Entgegenhaltungen:
- EP-A- 0 448 077
- WO-A-96/13621
- US-A- 5 024 716
- US-B1- 6 407 359
- US-B1- 6 433 298

## Beschreibung

### Technisches Gebiet

Die Erfindung betrifft einen ECR-Plasmaquelle nach dem Oberbegriff des Anspruchs 1, insbesondere für die Behandlung von Oberflächen im Niederdruckbereich, z.B. zur Oberflächenaktivierung, der Reinigung, dem Abtrag oder der Beschichtung von Substraten. Die ECR-Plasmaquelle besteht aus einer koaxialen Mikrowellenzuführung mit einem Innen- und Außenleiter, die isoliert einen Vakuumflansch durchdringt, welcher eine Öffnung in der Wand zum Plasmaraum abschließt. Weiterhin umfasst die ECR-Plasmaquelle eine Antenne, die als ein Ende des Innenleiters den Vakuumflansch isoliert durchdringt, und eine koaxial zur Mikrowellenzuführung angeordneten Multipolmagnetanordnung, deren Magnetfelder den Vakuumflansch durchdringen und im Plasmaraum um die Antenne ein Ringmagnetfeld ausbilden.

### Stand der Technik

Nach dem Stand der Technik sind vielfältige ECR-Plasmaquellen sowie Plasma- und Ionenstrahlverfahren bekannt. Z.B. gibt die EP 0 448 077 B1 ein Mikrowellen-Plasmatron zur Erzeugung einer durch ein Magnetfeld gestützten Mikrowellen-Entladung, bestehend aus einem Entladungsraum, einer Einkoppelanordnung für die Mikrowellen in den Entladungsraum und Magnete an. Auf einem Oberflächenwellenleiter ist ein oder sind mehrere hohlzylinderförmige Magnete angeordnet, die von einem U-förmig ausgebildeten Mantel aus ferromagnetischem Material in der Art umschlossen sind, dass die offene Seite am Oberflächenwellenleiter anliegt, und zentrisch zum hohlzylinderförmigen Magneten die Einkoppelanordnung für die Mikrowellen angebracht ist. Die Vakuumabtrennung des Entladungsraumes von der Einkoppelstelle der Mikrowellen wird von einem Quarzglasbecher gewährleistet, der für die Mikrowellen durchlässig ist. Die hohlzylinderförmigen Magnete können Spulen oder Permanentmagnete sein.

Durch die Kombination der Entladung mit Magnetfeldern wird der Elektron-Zyklotron-Effekt, kurz ECR-Effekt genannt, genutzt. Damit kann insbesondere der Einsatzdruckbereich zu sehr niedrigeren Drucken, bis ca. 10⁻⁵mbar, erweitert werden.

Beispielhaft wird das Mikrowellen-Plasmatron in einem Druckbereich von 10⁻² Pa bei einer Mikrowellenleistung von 400 W betrieben und ein Plasma sicher gezündet. Unabhängig von der Gasart werden Ionendichten zwischen 3 bis 10 x 10¹⁰ cm⁻³ erreicht. Aus dem Plasma werden Ionenströme mit homogenen Stromdichteverteilungen bis 3 mA/cm² über 6 Zoll Durchmesser extrahiert.

In der praktischen Anwendung derartiger Plasmaquellen ist insbesondere nachteilig, dass erhebliche Wartungsmaßnahmen des Entladungsraumes erforderlich sind. So wird eine häufige Reinigung des Beschichtungssystems notwendig, wodurch die Kosten des Beschichtungsverfahren erheblich steigen.

Je nach den eingesetzten Schichtmaterialien ergeben sich insbesondere bei Plasma-Beschichtungsverfahren elektrisch wenig leitfähige bis hoch leitfähige Schichten. Die aufwachsenden Schichten belegen dabei nicht nur die verwendeten Probenkörper, sondern mehr oder weniger auch alle in unmittelbarer Umgebung befindlichen Oberflächen von Bauteilen des gesamten Beschichtungssystems. Das kann zur zeitabhängigen Beeinflussung des Beschichtungsergebnisses führen bzw. schränkt die möglichen Beschichtungszeiten ein.

Häufige Ursache für die Einschränkung der Beschichtungsdauer sind leitfähige Schichten, die auf Spannungs- oder Stromdurchführungen Kurzschlüsse erzeugen bzw. auf den Koppelfenstern von elektrodenlosen Plasmaquellen die weitere Einkopplung von elektrischer Leistung verhindern.

### Darstellung der Erfindung

Der Erfindung liegt damit als Aufgabe zugrunde, eine ECR-Plasmaquelie anzugeben, die in einfacher Weise die Nachteile des Standes der Technik behebt und lange störungsfreie Betriebszeiten der ECR-Plasmaquelle ermöglicht.

Die Erfindung löst die Aufgabe durch die im Anspruch 1 angegebenen Merkmale. Vorteilhafte Weiterbildungen der Erfindung sind in den Unteransprüchen gekennzeichnet und werden nachstehend zusammen mit der Beschreibung der bevorzugten Ausführung der Erfindung, einschließlich der Zeichnung, näher dargestellt.

Eine ECR-Plasmaquelle nach dem Stand der Technik, bestehend aus einer koaxialen Mikrowellenzuführung mit einem Innenleiter und einem Außenleiter, wobei der Innenleiter mit einem Ende als Antenne isoliert einen Vakuumflansch durchdringt, der eine Öffnung in der Wand zum Plasmaraum abschließt, und einer koaxial zur Mikrowellenzuführung angeordneten Multipolmagnetanordnung, deren Magnetfelder den Vakuumflansch durchdringen und im Plasmaraum um die Antenne ein Ringspalt-Magnetfeld ausbilden, wird in vorteilhafter Weise weiter entwickelt.

Erfindungsgemäß ragt die Antenne direkt in den Plasmaraum. Ein nach dem Stand der Technik vorgesehener Quarzglasbecher oder Keramikbecher, der die Antenne umhüllt ist danach nicht vorhanden.

Der Plasmaraum im Sinne der Erfindung wird koaxial zur Antenne und zum Ringspalt-Magnetfeld durch eine Abschirmung begrenzt, die am Vakuumflansch gehaltert ist. Die Stirnseite der Abschirmung, die dem Vakuumflansch abgewandt ist, bildet die Plasmaaustrittsöffnung zur Vakuumkammer bzw. Plasma-Behandlungskammer.

Weiterhin weist die Antenne einen zum Innenleiter radial größeren Antennenkopf mit einer Unterseite parallel zum Vakuumflansch auf, derart dass zwischen dem Vakuumflansch und der Unterseite ein Ringspalt ausgebildet wird.

Die Höhe und die radiale Länge des Ringspaltes sowie die geometrische Anordnung der Abschirmung sind derart eingestellt, dass die radial innere Fläche des Ringspaltes gegenüber der Vakuumkammer bzw. Plasma-Behandlungskammer im optischen Schättenbereich liegt.

In vorteilhafter Weise ist die radiale Länge des Ringspaltes größer Lambda/4 der Erregerfrequenz. Die Höhe des Ringspaltes wird nach den bekannten Regeln zur Dimensionierung einer Dunkelraumabschirmung derart eingestellt, dass im Ringspalt ein Plasma-Schattenbereich ausgebildet wird und eine Plasmazündung mit Sicherheit ausgeschlossen ist.

Die der Unterseite des Antennenkopfes gegenüber liegende Koppelfläche der Antenne ist in vorteilhafter Weise mindestens teilweise als Kegel, Kegelstumpf oder Kugelsegment ausgebildet. Diese Oberflächengestaltung bewirkt eine vorteilhafte Abstrahlung der Mikrowellenleistung in Richtung des Ring-Magnetfeldes der Multipolmagnetanordnung, wodurch ein sicheres Zünden und Aufrechterhalten eines ECR-Plasmas im Bereich des Ring-Magnetfeldes gewährleistet ist. Dabei wirkt auch die Anordnung der Abschirmung koaxial zum Ringspalt-Magnetfeld zur Abgrenzung des Plasmaraumes in vorteilhafter Weise.

Das Trägergas und Reaktivgase können in bekannter Weise in die Vakuumkammer zugeführt werden. Dabei kann eine Zuführung, z.B. für das Trägergas, auch über eine Bohrung axial im Innenleiter vorgesehen werden. Die Austrittsöffnung der Gaszuführung kann dabei direkt im Bereich der Abstrahlung der Mikrowellenleistung von der Antenne liegen.

Die erfindungsgemäßen ECR-Plasmaquellen können zur Plasmabehandlung größerer Flächen auch in einer Vielzahl einzelner ECR-Plasmaquellen parallel in Form von Zeilen und Spalten als Array angeordnet sein.

### Ausführungsbeispiele

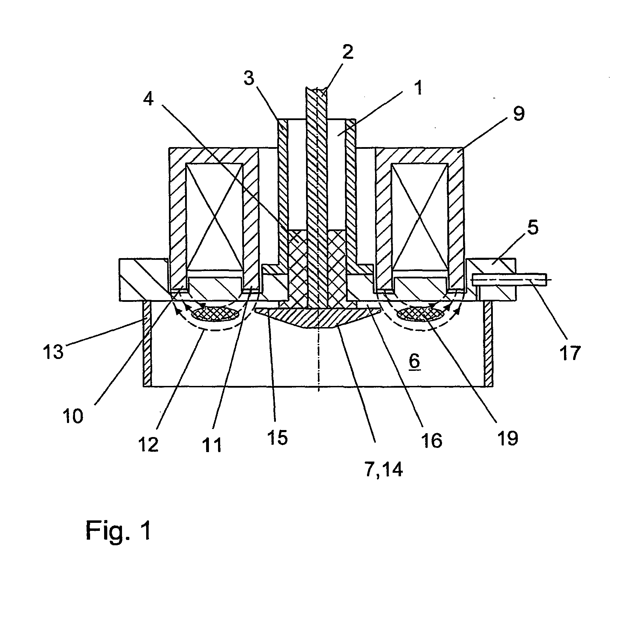

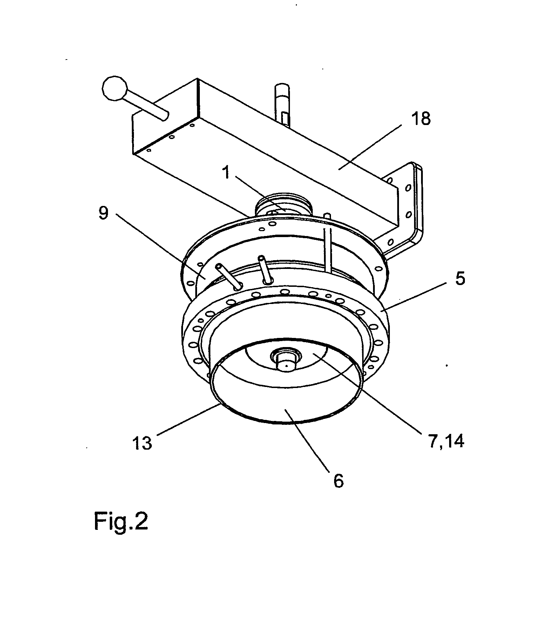

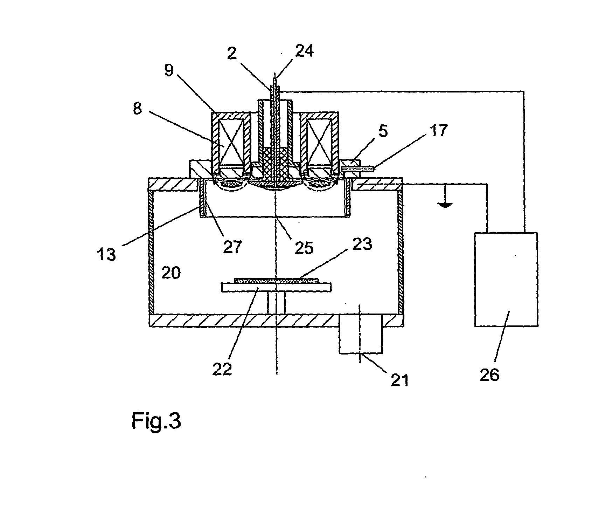

Die Erfindung wird nachstehend an zwei Ausführungsbeispielen näher erläutert. Zugehörig zum Ausführungsbeispiel I zeigt Figur 1 einen Schnitt durch eine erfindungsgemäße ECR-Plasmaquelle. Figur 2 zeigt eine perspektivische Gesamtdarstellung der ECR-Plasmaquelle nach Figur 1. Figur 3 zeigt zugehörig zum Ausführungsbeispiel II eine gegenüber Figur 1 abgewandelte ECR-Plasmaquelle in einer Plasma-Beschichtungseinrichtung.

### Ausführungsbeispiel I

Figur 1 zeigt den prinzipiellen Aufbau einer erfindungsgemäßen ECR-Plasmaquelle. Die ECR-Plasmaquelle besteht aus einer koaxialen Mikrowellenzuführung 1 mit einem Innenleiter 2 und einem zum Innenleiter 2 koaxialen Außenleiter 3. Der Innenleiter 2 ist gegenüber dem Außenleiter 3 durch einen dielektrischen Körper 4 isoliert. Dabei gewährleistet der dielektrischen Körper 4 gleichzeitig, dass der Innenleiter 2 einen Vakuumflansch 5 isoliert durchdringt, so dass das entsprechende Ende des Innenleiters 2 frei in den Plasmaraum ragt.

Der Vakuumflansch 5 ist als Montageflansch ausgebildet, der eine Öffnung in der Wand zum Plasmaraum 6 vakuumdicht abschließt.

Das Ende des Innenleiters 2, welches den Vakuumflansch 5 durchdringt und in den Plasmaraum 6 hinein ragt, bildet die Antenne 7 der Mikrowellenzuführung 1. Koaxial zur Mikrowellenzuführung 1 ist außerhalb des Plasmaraumes 6 eine mit Permanentmagneten bestückte Multipolmagnetanordnung 8 mit einem Eisenmantel 9 angeordnet. Im Bereich von Polschuhen 10 und 11 des Eisenmantels 9 wird koaxial um die Antenne 7 ein Ringspalt-Magnetfeld 12 erzeugt, welches den Vakuumflansch 5 durchdringt und in den Plasmaraum 6 hineinreicht.

Koaxial zur Antenne 7 und radial außerhalb des Ringspalt-Magnetfeldes 12 ist eine Abschirmung 13 angeordnet, deren dem Vakuumflansch abgewandte Stirnfläche die Plasmaaustrittsöffnung 25 bildet. Die Abschirmung 13 begrenzt den Plasmaraum 6 und beeinflusst vorteilhaft die Ausbildung eines ECR-Plasmas im Plasmaraum 6.

Erfindungsgemäß ist die Antenne 7 als ein gegenüber dem Innenleiter 2 radial vergrößerter Antennenkopf 14 ausgebildet, der parallel zum Vakuumflansch 5 eine Unterseite 15 aufweist, derart, dass zwischen dem Vakuumflansch 5 und der Unterseite 15 des Antennenkopfes 14 ein Ringspalt 16 ausgebildet wird. Gegenüber seiner Unterseite 15 ist der Antennenkopf 14 in der Form eines Kegelstumpfes ausgebildet. Dadurch erfolgt eine vorteilhafte Abstrahlung der Mikrowellenleistung in Richtung des Ringspalt-Magnetfeldes 12.

Im Ausführungsbeispiel I erfolgt die Zuführung eines Trägergase oder Reaktivgases über eine Bohrung 17 im Vakuumflansch 5.

Zum besseren Verständnis der ECR-Plasmaquelle nach Ausführungsbeispiel I zeigt Figur 2 noch eine perspektivische Darstellung der ECR-Plasmaquelle. Ergänzend zu Figur 1 ist ein Mikrowellen-Applikator 18 erkennbar, der als Wellentransförmator zwischen einem Rechteck-Hohlleiter und der Mikrowellenzuführung 1 sowie zur groben Mikrowellen-Anpassung an einen hier nicht dargestellten Mikrowellen-Generator dient.

### Ausführungsbeispiel II

Figur 3 zum Ausführungsbeispiel II zeigt eine ähnliche Ausführung der ECR-Plasmaquelle wie in Figur 1, jedoch in einer schematischen zusammenschau mit einer Beschichtungseinrichtung, im Wesentlichen bestehend aus einer Vakuumkammer 20 mit einem Pumpstutzen 21 und einem Substratträger 22, auf dem zu behandelnde Substrate 23 positioniert werden können.

Die erfindungsgemäße ECR-Plasmaquelle ist mit der Plasmaaustrittsöffnung 25, diese entspricht der dem Vakuumflansch 5 abgewandten Stirnseite der Abschirmung 13, parallel gegenüber dem Substratträger 22 angeordnet.

Zusätzlich zur Bohrung 17 entsprechend Ausführungsbeispiel I ist zentrisch im Innenleiter 2 eine Bohrung 24 vorhanden. Über die beiden Bohrungen 17 und 24 können wahlweise Trägergas und Reäktivgase in die Vakuumkammer 20 zugeführt werden.

Wie im Ausführurigsbeispiel I ist der Innenleiter 2 und die Antenne 7 im Außenleiter 3 der Mikrowellenzuführung 1 isoliert angeordnet. Damit kann eine zusätzliche Spannungsversorgung 26 an den Innenleiter 2 mit der Antenne 7 angeschlossen werden. Im Ausführungsbeispiel II ist weiterhin die Abschirmung 13 innen mit einer isolierenden Auskleidung 27 versehen. Dadurch kann das ECR-Plasma, gegenüber Masse-Potential, auf verschieden hohe Potenziale eingestellt werden.

Zur Spannungsversorgung können wahlweise sowohl Gleichspannungs- als auch Wechselspannungsquellen eingesetzt werden. Wird z.B. an der Mikrowellenzuführung 1 ein gegenüber Masse-Potenzial positiveres Potential eingestellt, so setzt eine Extraktion von Ionen in Richtung der z.B. auf Masse-Potenzial liegenden Substrate 23 ein. Wird eine Wechselspannung angeschlossen, so kommt es zu einer Überlagerung mit dem ECR-Plasma, wodurch ein alternierendes Randschichtpotenzial gebildet wird. Je nach der momentanen Polarität und Größe des Randschichtpotenziales des ECR-Plasmas, im Bezug zum Substratpotenzial, werden Ionen bzw. Elektronen unterschiedlicher Dichte extrahiert. Die ECR-Plasmaquelle wird dann zur Plasmastrahlquelle.

Die konkrete erfindungsgemäße ECR-Plasmaquelle kann beispielsweise folgende Konstruktionsmaße aufweisen. Die Abmessungen des Vakuumflansches 5 entsprechen dabei dem ISO-Standard 3669 für DN 160 CF. Der Plasmaraum 6 wird durch die topfförmige Abschirmung 13 mit einer Höhe von 45 mm und einem Durchmesser von 145 mm bestimmt. Die innere, isolierende Auskleidung 27 hat entsprechende Maße. Wahlweise kann die Auskleidung auch auswechselbar sein und aus anderen Materialien, z.B. Aluminiumfolie, bestehen.

Der Antennenkopf 14 in der die Form eines Kegelstumpfes hat eine Höhe von 25 mm und einen Durchmesser an der Unterseite 15 von 80 mm und ist aus Edelstahl gefertigt.

Der Ringspalt 16 zwischen dem Vakuumflansch 5 und der Unterseite 15 weist eine Höhe von 4 mm und eine radiale Länge von 30 mm auf. Damit ist im typischen Einsatzbereich einer ECR-Plasmaquelle bei einem Druck von 1x10⁻⁴ bis 1x10⁻² mbar im Ringspalt 16 keine Plasmazündung möglich.

Im Zusammenwirken mit der Abschirmung 13 liegt damit die radial innere Fläche des Ringspaltes 16 in vorteilhafter Weise gegenüber der Vakuumkammer bzw. Plasma-Behandlungskammer im optischen Schattenbereich. Zusätzlich liegt die radial innere Fläche des Ringspaltes 16 im Plasma-Schattenbereich, so dass der Ringspalt 16 auch durch im Plasma bewegte Partikel nicht beschichtet werden kann.

Nachfolgend wird die ECR-Plasmaquelle im Einsatz zur plasmagestützten Schichtabscheidung näher beschrieben.

Nach der Einstellung der erforderlichen Atmosphäre in der Vakuumkammer 20 mit dem Plasmaraum 6 wird über den Mikrowellen-Applikator 18 der Mikrowellenzuführung 1 die Mikrowellenleistung zugeführt und vom Antennenkopf 14 der Antenne 7 in den Plasmaraum 6 abgestrahlt. Durch die besondere Form des Antennenkopfes 14 im Bezug zur Abschirmung 13 wird das Ringspalt-Magnetfeld 14 mit der Mikrowellenleistung überlagert und im Plasmaraum 6 kommt es zur Ausbildung eines Elektron-Zyklotron-Effektes, d.h. es wird in diesem Bereich ein ECR-Plasma 19 gezündet und aufrecht erhalten.

Die erfindungsgemäße Ausbildung des Antennenkopfes 14 der Antenne 7 ermöglicht in überraschender Weise die Abstrahlung der Mikrowellenleistung, ohne dass bereits an der Antenne 7 eine unerwünschte Plasmazündung erfolgt, was zur Einschränkung der Strahlereigenschaften der Antenne führen könnte. Das wird im Wesentlichen durch die besondere Form des Antennenkopfes 14 und die geometrische Anordnung der Abschirmung 13 zur Begrenzung des Plasmaraumes 6 in Bezug zum Ort des Ringspalt-Magnetfeldes 12, wo sich das ECR-Plasma 19 ausbildet.

Von besonderem Vorteil ist die einfache Ausbildung des Ringspaltes 16, zwischen der Unterseite 15 des Antennenkopfes 14 und dem Vakuumflansch 5. Im Ausführungsbeispiel wird der Ringspalt 16 in einfacher Weise durch die Gestaltung des Antennenkopfes 14 als Kegelstumpf ausgebildet. Die besondere Form des Antennenkopfes 14 erfüllt auch alle Voraussetzungen für einen vorteilhaften Mikrowellen-Strahler.

Durch Veränderung der Höhe und des Durchmessers des Kegelstumpfes können die Strahlereigenschaften der Antenne 7 und die radiale Länge des Ringspaltes 16 in einfacher Weise variiert werden. Wird die Spaltlänge mindestens Lambda/4 (Wellenlänge/4) der Erregerfrequenz eingestellt, so wirkt sich das vorteilhaft auf die Strahlereigenschaften der Antenne 7 aus. Eine unerwünschte Plasmazündung direkt an der Antenne mit der Folge eines Kurzschlusses der Entladung wird verhindert.

Von besonderer Bedeutung ist dabei, dass die radial innere Fläche des Ringspaltes 16 bei der Abscheidung leitfähiger wie isolierender Schichten, nicht beschichtet wird, so dass die bei Lösungen nach dem Stand der Technik bereits in kurzen Zeitabständen erforderlichen Wartungsarbeiten entfallen.

Die Form des erzeugten ECR-Plasmas 19 kann leicht empirisch mit der Höhe der Abschirmung 13 sowie mit dem Abstand der Abschirmung 13 zur Antenne 7 angepasst bzw. beeinflusst werden.

In einer spezifischen Anwendung wurde die ECR-Plasmaquelle zur Abscheidung von harten amorphen Kohlenstoffschichten eingesetzt. Dabei wurde als Reaktivgas und Kohlenstoffträger in der Beschichtungskammer eine Atmosphäre mit Acetylen eingesetzt. Der Prozessdruck betrug ca. 5x10⁻⁴ mbar. Bei einem Abstand der Substraten 23 zur Plasmaaustrittsöffnung 25 an der Abschirmung 13 der ECR-Plasmaquelle von ca. 100 mm konnten je nach eingesetzter Mikrowellen-Leistung eine mittlere Beschichtungsrate von ca. 20 nm/min bis ca. 40 nm/min erreicht werden.

Bei einem Beschichtürigstest über 40 h Beschichtungsdauer, mit den oben genannten Prozessparametern, konnten keine Änderungen in der Mikrowellen-Anpassung, sowie in der Stabilität des ECR-Plasmas beobachtet werden. Die Schichtdicke der abgeschiedenen Kohlenstoffschicht betrug dabei ca. 100 µm. Diese Ergebnisse zeigen eine besondere Tauglichkeit der erfindungsgemäßen ECR-Plasmaquelle bei der Abscheidung von leitfähigen Dünnschichten.

### Liste der verwendeten Bezugszeichen

| | | | |
|---|---|---|---|
| 1 | Mikrowellenzuführung | 2 | Innenleiter |
| 3 | Außenleiter | 4 | dielektrischer Körper |
| 5 | Vakuumflansch | 6 | Plasmaraum |
| 7 | Antenne | 8 | Multipolmagnetanordnung |
| 9 | Eisenmantel | 10 | Polschuh |
| 11 | Polschuh | 12 | Ringspalt-Magnetfeld |
| 13 | Abschirmung | 14 | Antennenkopf |
| 15 | Unterseite | 16 | Ringspalt |
| 17 | Bohrung | 18 | Mikrowellen-Applikator |
| 19 | ECR-Plasma | 20 | Vakuumkammer |
| 21 | Pumpstutzen | 22 | Substratträger |
| 23 | Substrat | 24 | Bohrung |
| 25 | Plasmaaustrittsöffnung | 26 | Spannungsversorgung |
| 27 | isolierende Auskleidung | | |

## Patentansprüche

1. ECR-Plasmaquelle, bestehend aus einer koaxialen Mikrowellenzuführung (1) mit einem Innenleiter (2) und einem Außenleiter (3), wobei der Innenleiter (2) mit einem Ende als Antenne (7) isoliert einen Vakuumflansch (5) durchdringt, welcher eine Öffnung in der Wand zum Plasmaraum (6) abschließt, und einer koaxial zur Mikrowellenzuführung (1) angeordneten Multipolmagnetanordnung (8), deren Magnetfelder den Vakuumflansch (5) durchdringen und im Plasmaraum (6) koaxial zur Antenne (7) ein Ringspalt-Magnetfeld (12) ausbilden, **dadurch gekennzeichnet, dass** die Antenne (7) direkt in den Plasmaraum (6) ragt und gegenüber dem Innenleiter (2) einen radial größeren Antennenkopf (14) aufweist, an dem parallel zum Vakuumflansch (5) eine Unterseite (15) vorgesehen ist, derart dass zwischen dem Vakuumflansch (5) und der Unterseite (15) ein Ringspalt (16) ausgebildet wird, und dass der Plasmaraum (6) koaxial zur Antenne (7) und radial außerhalb des Ringspalt-Magnetfeldes (12) durch eine Abschirmung (13) begrenzt wird, deren dem Vakuumflansch abgewandte Stirnseite die Plasmaaustrittsöffnung (25) definiert.

2. ECR-Plasnaquelle nach Anspruch 1, weiter **dadurch gekennzeichnet, dass** die radial innere Fläche des Ringspaltes (16) im optischen Schatten zwischen der Plasmaaustrittsöffnung (25) und der äußeren Kante an der Unterseite (15) am Antennenkopf (14) liegt.

3. ECR-Plasmaquelle nach Anspruch 1 oder 2, weiter **dadurch gekennzeichnet, dass** die radiale Länge des Ringspaltes (16) größer Lambda/4 der Erregerfrequenz ist und die Höhe des Ringspaltes (16) derart eingestellt ist, dass im Ringspalt ein Plasma-Schattenbereich ausgebildet wird und eine Plasmazündung mit Sicherheit ausgeschlossen ist.

4. ECR-Plasmaquelle nach einem der vorangegangenen Ansprüche, weiter **dadurch gekennzeichnet, dass** der Antennenkopf (14) gegenüber seiner Unterseite (15) eine Koppelfläche aufweist, die mindestens teilweise als Kegel, Kegelstumpf oder Kugelsegment ausgebildet ist.

5. ECR-Plasmaquelle nach einem der vorangegangenen Ansprüche, weiter **dadurch gekennzeichnet, dass** axial im Innenleiter (2) eine Bohrung zur Zuführung eines Prozessgases vorhanden ist.

6. ECR-Plasmaquelle nach einem der vorangegangenen Ansprüche, weiter **dadurch gekennzeichnet, dass** der Innenleiter (2) zusätzlich mit einer Spannungsquelle (26) verbunden ist und die Abschirmung (13) eine isolierende Auskleidung (27) aufweist.

7. ECR-Plasmaquelle nach einem der vorangegangenen Ansprüche, weiter **dadurch gekennzeichnet, dass** eine Vielzahl einzelner ECR-Plasmaquellen zur Plasmabehandlung größerer Flächen parallel in Form von Zeilen und Spalten als Array angeordnet sind.

## Claims

1. ECR plasma source, comprising a coaxial microwave supply (1) having an inner conductor (2) and an outer conductor (3), wherein one end, as an antenna (7), of the inner conductor (2) passes in an insulated manner through a vacuum flange (5) which closes an opening in the wall to the plasma space (6) and having a multipole magnet arrangement (8) which is arranged coaxially with respect to the microwave supply (1) and whose magnetic fields pass through the vacuum flange (5) and form an annular gap magnetic field (12) coaxially with respect to the antenna (7) in the plasma space (6), **characterized in that** the antenna (7) projects directly into the plasma space (6) and has an antenna head (14) which is radially larger than the inner conductor (2) and on which an underside (15) is provided parallel to the vacuum flange (5) such that an annular gap (16) is formed between the vacuum flange (5) and the underside (15), and such that the plasma space (6) is bounded coaxially with respect to the antenna (7) and radially outside the annular gap magnetic field (12) by a shield (13) whose end face facing away from the vacuum flange defines the plasma outlet opening (25).

2. ECR plasma source according to Claim 1, further **characterized in that** the radially inner surface of the annular gap (16) is located in the optical shadow between the plasma outlet opening (25) and the outer edge on the underside (15) on the antenna head (14).

3. ECR plasma source according to Claim 1 or 2, further **characterized in that** the radial length of the annular gap (16) is greater than lambda/4 of the exciter frequency, and the height of the annular gap (16) is set such that a plasma shadow area is formed in the annular gap and plasma initiation is reliably precluded.

4. ECR plasma source according to one of the preceding claims, further **characterized in that** the antenna head (14) has a coupling surface opposite its underside (15), which coupling surface is at least partially in the form of a cone, a truncated cone or a sphere segment.

5. ECR plasma source according to one of the preceding claims, further **characterized in that** a bore for supplying a process gas is provided axially in the inner conductor (2).

6. ECR plasma source according to one of the preceding claims, futher **characterized in that** the inner conductor (2) is additionally connected to a voltage source (26), and the shield (13) has insulating cladding (27).

7. ECR plasma source according to one of the preceding claims, further **characterized in that** a multiplicity of individual ECR plasma sources for plasma treatment of relatively large areas are arranged parallel, in the form of rows and columns, as an array.

## Revendications

1. Source de plasma ECR constituée d'une amenée coaxiale (1) de microondes dotée d'un conducteur intérieur (2) et d'un conducteur extérieur (3),
le conducteur intérieur (2) dont une extrémité forme une antenne (7) traversant de manière isolée une bride (5) sous vide qui ferme une ouverture ménagée dans la paroi de l'espace (6) à plasma,
et d'un système (8) d'aimants multipolaires disposés coaxialement par rapport à l'amenée (1) de microondes et dont les champs magnétiques traversent la bride (5) sous vide et forment dans l'espace (6) à plasma un champ magnétique (12) un interstice annulaire coaxial par rapport à l'antenne (7),
**caractérisée en ce que**
l'antenne (7) pénètre directement dans l'espace (6) à plasma et présente une tête (14) d'antenne dont le rayon est plus grand que celui du conducteur intérieur (2) et dont le côté inférieur (15) parallèle à la bride (5) sous vide est prévu de telle sorte qu'entre la bride (5) sous vide et le côté inférieur (15) soit formé un interstice (16) et
**en ce que** l'espace (6) à plasma est délimité coaxialement par rapport à l'antenne (7) et radialement à l'extérieur du champ magnétique (12) en interstice annulaire par un blindage (13) dont le côté frontal non tourné vers la bride sous vide définit l'ouverture (25) de sortie du plasma.

2. Source de plasma ECR selon la revendication 1, **caractérisée en outre en ce que** la surface radialement intérieure de l'interstice annulaire (16) est située sur le côté inférieur (15) de la tête (14) de l'antenne dans l'ombre optique entre l'ouverture (25) de sortie du plasma et le bord extérieur.

3. Source de plasma ECR selon les revendications 1 ou 2, **caractérisée en outre en ce que** la longueur radiale de l'interstice annulaire (16) est supérieure à lambda/4 de la fréquence d'excitation et **en ce que** la hauteur de l'interstice annulaire (16) est établie de telle sorte qu'une zone d'ombre de plasma soit formée dans l'interstice annulaire et qu'un allumage du plasma y soit exclu de manière sûre.

4. Source de plasma ECR selon l'une des revendications précédentes, **caractérisée en outre en ce que** la tête (14) de l'antenne présente une surface d'accouplement à son côté inférieur (15), au moins en partie de cette surface d'accouplement étant configurée en cône, en tronc de cône ou en segment de cône.

5. Source de plasma ECR selon l'une des revendications précédentes, **caractérisée en outre en ce qu'**un alésage qui amène un gaz de traitement est prévu axialement dans le conducteur intérieur (2).

6. Source de plasma ECR selon l'une des revendications précédentes, **caractérisée en outre en ce que** le conducteur intérieur (2) est de plus relié à une source de tension (26) et **en ce que** le blindage (13) présente un habillage isolant (27).

7. Source de plasma ECR selon l'une des revendications précédentes, **caractérisée en outre en ce que** plusieurs sources de plasma ECR différentes destinées à traiter par plasma de plus grandes surfaces sont disposées parallèlement en un ensemble constitué de lignes et de colonnes.
